# EUROPÄISCHE PATENTSCHRIFT

(11) **EP 2 125 443 B1**
(45) Veröffentlichungstag und Bekanntmachung des Hinweises auf die Patenterteilung: **02.11.2011**
(21) Anmeldenummer: 08716738.3
(22) Anmeldetag: 07.01.2008
(51) Int. Cl.: B60R 21/01, G08C 15/12, G08C 15/10

(54) **STEUERGERÄT FÜR DEN PERSONENSCHUTZ UND VERFAHREN ZUR ANSTEUERUNG VON MITTELN ZUM PERSONENSCHUTZ**
CONTROL DEVICE FOR PERSONAL PRIVACY AND METHOD FOR SELECTING MEANS FOR PERSONAL PRIVACY
DISPOSITIF DE COMMANDE POUR LA PROTECTION DE PERSONNES ET PROCEDE DE COMMANDE D'ELEMENTS POUR LA PROTECTION DE PERSONNES

(30) Priorität: 21.02.2007 DE 102007008383
(43) Veröffentlichungstag der Anmeldung: 02.12.2009
(73) Patentinhaber: Robert Bosch GmbH, 70442 Stuttgart (DE)
(72) Erfinder: WEISS, Timo, 70825 Korntal (DE)
(86) Internationale Anmeldenummer: PCT/EP2008/050092
(87) Internationale Veröffentlichungsnummer: WO 2008/101741

(56) Entgegenhaltungen:
- EP-A- 1 239 352
- DE-A1- 10 114 504
- DE-A1- 10 128 753
- DE-A1-102005 041 914
- US-A1- 2002 133 662

## Beschreibung

### Stand der Technik

Die Erfindung betrifft ein Steuergerät für den Personenschutz bzw. ein Verfahren zur Ansteuerung von Mitteln zum Personenschutz nach der Gattung der unabhängigen Patentansprüche.

Aus DE 101 49 332 A1 ist es bereits bekannt, dass von einem Sensor, der sich außerhalb eines Steuergeräts für den Personenschutz befindet, Manchestercodierte Daten zu einem Steuergerät übertragen werden und dort durch eine Schnittstelle bereitgestellt werden. Die Manchestercodierten Daten werden decodiert und in Abhängigkeit von diesen decodierten Daten kommt es zur Ansteuerung von Mitteln zum Personenschutz.

Aus DE 101 14 504 A1 ist ein Verfahren zur Übertragung von Daten von einem Sensor zu einem Steuergerät gemäß Oberbegriffen der Ansprüche 1 and 10 bekannt. Dabei werden die Daten im Manchestercode übertragen. Im Steuergerät werden die Daten von einem Mikrocontroller verarbeitet, um ein Rückhaltesystem eines Fahrzeugs anzusteuern.

### Offenbarung der Erfindung

Das erfindungsgemäße Steuergerät bzw. das erfindungsgemäße Verfahren zur Ansteuerung für Mittel zum Personenschutz mit den Merkmalen der unabhängigen Patentansprüche haben demgegenüber den Vorteil, dass eine Schieberregisterstruktur für die Decodierung der Manchestercodierten Signale vorgeschlagen wird und somit ein hohes Maß an Robustheit gegenüber Störungen wie Rauschen, Impulsstörungen und thermischen Effekten erreicht wird, ohne dabei die Komplexität signifikant zu erhöhen. Auch die Überabtastung trägt zur erhöhten Robustheit der Signaldetektion bei. Durch die Überabtastung wird ein Datenbit in eine Mehrzahl von Abtastwerten aufgeteilt, die in die Schieberegister geschoben werden können. Damit ist die Detektion eines Datenbits sehr sicher möglich.

Bei der Manchestercodierung ist die Information in einem Flankenwechsel codiert. Die Schnittstelle ist vorliegend ein integrierter Schaltkreis, es kann sich jedoch auch um diskrete Bauelemente handeln oder eine Kombination aus integrierten und diskreten Bauelementen. Auch eine Softwareausführung der Schnittstelle oder zumindest Teilweiseausführung der Schnittstelle ist vorliegend möglich. Als Mittel für den Personenschutz sind Airbags, Gurtstraffer, crashaktive Kopfstützen, Fußgängerschutzmittel und Überrollbügel und anderes möglich. Bei dem Signal handelt es sich üblicherweise um ein Sensorsignal, aber es ist möglich, dass es sich dabei auch um Signale anderer Steuergeräte handelt, die das Signal bereits vorverarbeitet haben oder eine Entscheidung, die anhand eines Sensorsignals oder Sensorsignale getroffen wurde zum erfindungsgemäßen Steuergerät übertragen. Als Sensoren kommen beispielsweise Aufprallsensoren und/oder Umfeldsensoren in Frage.

Die Decodiereinheit kann ein eigener elektronischer Baustein sein. Es ist jedoch möglich, dass sie auch als Softwareelement auf einem Mikrocontroller im Steuergerät oder einem anderen Prozessor vorhanden ist. Auch ein programmierbarer integrierter Schaltkreis ist vorliegend möglich. Auch eine Lösung aus diskreten Bausteinen ist möglich.

Bei der Auswerteeinheit handelt es sich üblicherweise um einen Mikrocontroller oder einen anderen Prozessor. Es ist jedoch möglich, dass es sich dabei auch um sogenannte ASICs oder diskrete Bauelemente handelt.

Bei der Schieberegisterstruktur kann es sich um alle möglichen Konfigurationen oder Kombinationen von Schieberegistern handeln. Letztlich ist auch ein einziges Schieberegister möglich.

Durch die in den abhängigen Ansprüchen aufgeführten Maßnahmen und Weiterbildungen sind vorteilhafte Verbesserungen des in den unabhängigen Patentansprüchen angegebenen Steuergeräts zum Personenschutz bzw. des in den unabhängigen Patentansprüchen angegebenen Verfahrens zur Ansteuerung von Mitteln zum Personenschutz möglich.

Besonders vorteilhaft ist, dass die Schieberegisterstruktur zwei hintereinander geschaltete gleich lange Schieberegister aufweist. Damit sind dann besonders einfache und robuste Methoden zur Decodierung des Manchestercodierten Signals möglich.

Weiterhin ist es vorteilhaft, dass für die zwei Schieberegister jeweils eine Addiervorrichtung zur Summenbildung von Inhalten der zwei Schieberegister vorgesehen ist. Dies bedeutet beispielsweise, dass laufend der gesamte Inhalt der jeweiligen Schieberegister aufsummiert wird, sodass diese beiden Summen dann weiterverarbeitet werden können, und zwar mittels einer Subtraktionsvorrichtung für die beiden Summen, die eine Differenz aus diesen beiden Summen bildet. Diese Differenz geht dann jeweils in zwei Zweige ein, und zwar zum einen in einen Zweig mit einem Betragsbilder und einem nachgeschalteten Schwellwertentscheider, um zu erkennen, ob eine eindeutige Entscheidung gefällt werden kann, um dass es sich bei dem empfangenen Bit handelt. Der zweite Zweig weist eine Vorzeichenerkennung mithin eine Signumfunktion auf, so dass damit die Detektion des Bits letztlich stattfindet. Der Schwellwertentscheider und die Vorzeichenerkennung sind jedoch jeweils an Ausgaben angeschlossen, bei denen es sich im einfachsten Fall um hardware- oder softwarerealisierte Schalter handelt. Diese Schalter werden vorzugsweise in Abhängigkeit von einer Extremwertsuche angesteuert, denn der Extremwert gibt an, wann die Detektion des Bits am besten stattfinden kann. Die vorliegend beschriebenen Elemente, wie die Schieberegister, die Addiervorrichtung, die Subtraktionsvorrichtung, die Betragsbilder, der Schwellwertentscheider sowie der Vorzeichenerkenner können alle softwaremäßig hergestellt werden. Auch die erste und zweite Ausgabe kann softwaremäßig realisiert sein, es ist jedoch möglich, dass auch diese Elemente zum Teil oder alle hardwaremäßig realisiert werden.

Es ist weiterhin vorteilhaft, dass, wie oben angegeben, an die Schieberegisterstruktur eine Extremwertsuche angeschlossen ist. Diese Extremwertsuche beeinflusst dann die Decodierung, beispielsweise wie oben angegeben dadurch, dass die Zeitpunkte festgelegt werden, wann die Detektion des Bits erfolgen soll. Wenn der entsprechende Extremwert gefunden wurde, kann beispielsweise die erste und zweite Ausgabe durchgeschaltet werden, da dann die Ausgabe des Vorzeichenerkenners und des Schwellwertentscheiders optimal sein müsste.

Der nachgeschaltete Mikrocontroller, also die Auswerteschaltung, nimmt beide Signale auf, das des Schwellwertentscheiders und das des Vorzeichenerkenners, um in Abhängigkeit von beiden Signalen zu entscheiden, ob die Verarbeitung des Bits beginnen kann oder nicht.

Es ist weiterhin vorteilhaft, dass die Extremwertsuche in Abhängigkeit von einem neuen Abtastwert, der also gerade am Eingang anliegt und den jeweils ältesten Abtastwerten des ersten und zweiten Schieberegisters bestimmt wird. Damit ist es dann leicht möglich, den Extremwert festzustellen. Der Extremwert kann insbesondere dadurch festgestellt werden, dass der Zeitpunkt bestimmt wird, bei dem ein Kennwert, der vorher gewachsen ist, nun wieder abnimmt. Eine genaue Ausführung kann folgende Gleichung erfüllen, um den Extremwert festzustellen. Der älteste Abtastwert des zweiten Schieberegisters wird zu dem neuen Abtastwert addiert und davon wird der älteste Abtastwert des ersten Schieberegisters zweimal abgezogen. Das erste Schieberegister ist dabei das Schieberegister, in das der neue Abtastwert zuerst hineinkommt und das zweite Schieberegister ist an diesem ersten Schieberegister nachgeschaltet, so dass der älteste Wert des zweiten Schieberegisters der älteste Wert überhaupt ist.

Die Schieberegisterstruktur weist insgesamt die Länge von dem Datenbit auf, wobei die Überabtastung die Zahl der Werte bestimmt. Die Überabtastung kann insbesondere mit dem Arbeitstakt, der sowieso vorhanden ist, des Steuergeräts verwendet werden.

Ausführungsbeispiele der Erfindung sind in der Zeichnung dargestellt und werden in der nachfolgenden Beschreibung näher erläutert

Es zeigen:
- Figur 1: ein Steuergerät mit einem abgesetzten Satelliten, vorzugsweise einem Sensor,
- Figur 2: zeigt den Aufbau des erfindungsgemäßen Decoders,
- Figur 3: zeigt einen Aufbau einer Extremwertsuche und
- Figur 4: zeigt ein Flussdiagramm des erfindungsgemäßen Verfahrens.

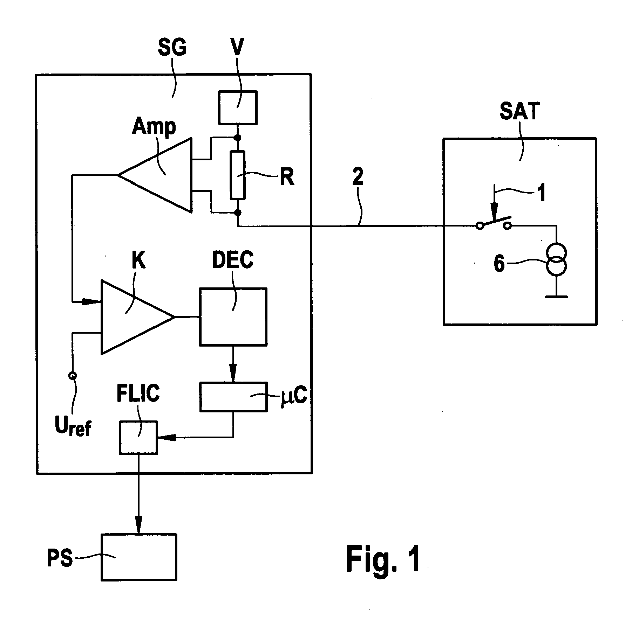

Figur 1 zeigt ein Steuergerät SG zur Ansteuerung von Personenschutzmitteln PS, an das ein Satellit SAT angeschlossen ist. Dieser Satellit SAT kann beispielsweise ein Aufprallsensor wie ein Beschleunigungssensor in der Fahrzeugseite, Fahrzeugfront oder ein Sensorcluster sein. Auch andere Sensoren, wie Körperschallsensoren, Luftdrucksensoren, Drehratensensoren können durch den Satelliten SAT zusätzlich oder anstatt repräsentiert sein. Es ist weiterhin möglich, dass auch andere Steuergeräte durch den Satelliten SAT repräsentiert werden. Vorliegend ist lediglich ein Satellit dargestellt, es ist jedoch möglich, dass eine Vielzahl von Satelliten an das Steuergerät SG in der gleichen Art und Weise angeschlossen sind. Der Satellit weist einen Stromgenerator 6 auf, der durch den elektrisch steuerbaren Schalter 1 moduliert wird. Diese Modulation erfolgt über eine Steuerschaltung, die in Abhängigkeit beispielsweise von Sensorwerten die Modulation durchführt. Vorliegend wird die Information in einem Manchestercode codiert. Die Stromimpulse werden dann einfach dem über die Datenübertragungsleitung 2 fließenden Ruhestrom des Satelliten 3 überlagert. Im Steuergerät SG ist zwischen einer Spannungsquelle V und der Datenübertragungsleitung ein Messwiderstand R angeordnet. Die daran abfallende Signalspannung, die proportional zu dem über die Datenübertragungsleitung 2 fließenden Signalstrom ist, wird über einen Verstärker AM P einem Komparator K zugeführt und durch diesen Komparator K mit einer Referenzspannung U_{ref} verglichen. Bei entsprechender Wahl von U_{ref} kann am Komparator K der Zustand der Übertragungsleitung geschätzt werden. Ist die Signalspannung kleiner als die Referenzspannung U_{ref}, so deutet dies darauf hin, dass momentan keine Daten übermittelt werden und somit über die Datenübertragungsleitung 2 lediglich der Ruhestrom fließt. Am Ausgang des Komparators K liegt in diesem Fall ein niedriger Pegel an.

Der Ausgang des Komparators K wird abgetastet und digital weiterverarbeitet, und zwar durch den Decoder DEC. Durch diese Abtastung bei der Verarbeitung soll die dem Strom modulierten Wellenzug auf der Übertragungsleitung 2 zugrunde liegende Sendesequenz geschätzt werden. Daher muss nun eine Manchesterdecodierung durch den Decoder DEC erfolgen. Dies ist erfindungsgemäß ausgebildet. Das dann decodierte Signal wird an einen Mikrocontroller µC weitergegeben, der in Abhängigkeit von diesem Signal und auch anderen Signalen, die der Einfachheit halber, wie auch andere Komponenten des Steuergeräts vorliegend nicht dargestellt sind, ein Ansteuersignal erzeugt und an einer Ansteuerungsschaltung FLIC überträgt, die dann die Ansteuerung der Personenschutzmittel PS vornimmt.

Erfindungsgemäß wird der binäre Ausgang des Komparators K abgetastet, typischerweise mit dem Systemtakt des Steuergeräts SG, beispielsweise 2 MHz. Der so entstehende binäre Strom wird dann eine Schieberegisterstruktur eingespeist, die vorzugsweise in zwei Hälften unterteilt ist. Die Länge der Schieberegisterblöcke entspricht jeweils der Länge eines halben Bits in Abtastwerten, beispielsweise wenn die Bitdauer 8 ms ist und die Abtastrate von 2 MHz verwendet wird, kommen so 8 Abtastwerte pro Schieberegisterblock zustande. Damit ist dann über die gesamte Schieberegisterstruktur eine Speicherung der Abtastwerte des Manchesterwellenzugs eines Datenbits vorgenommen worden.

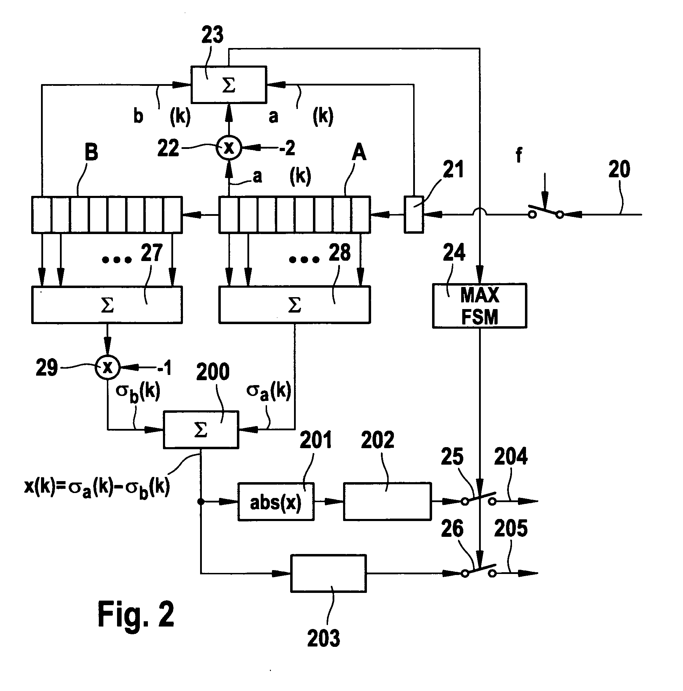

Mit dem Bezugszeichen 20 ist der Ausgang des Komparators K gekennzeichnet. Hier liegt also der binäre Ausgangsstrom des Komparators K an. Dieser binäre Ausgangsstrom wird nunmehr überabgetastet, und zwar mit der Frequenz fₛₐₘₚₗₑ, was vorliegend, wie oben dargestellt, 2 MHz ist. Die Werte in Folge dieser Überabtastung gehen auf einen Verteiler 21, der einerseits mit dem ersten Schieberegister A und andererseits mit einer Recheneinheit 23 verbunden ist und diesen beiden Komponenten jeweils den neuen Abtastwert bereitstellt. Dem Register A ist das zweite Register B nachgeschaltet. Beide Register A und B sind jeweils an Addiervorrichtungen 28 und 27 angeschlossen, die den gesamten Inhalt des jeweiligen Registers A bzw. B aufaddieren, so dass diese Summen dann für die weitere Verarbeitung zur Verfügung stehen. Die Summe des Registerblocks A wird von der Addiervorrichtung 28 als σ*ₐ* (*k*) in die Addiervorrichtung 200 eingegeben. Die Summe des Schieberegisters B wird am Ausgang mit -1 durch den Multiplikator 29 multipliziert, so dass sich die Summe σ*_{b}*(*k*) ergibt. In der Addiervorrichtung 200 wird dann die Differenz σ*ₐ*(*k*)-σ*_{b}*(*k*) gebildet. Diese Differenz wird in Figur 2 mit x(k) gekennzeichnet. Der Wert x(k) geht sowohl an einen Betragsbilder 201 und eine Vorzeichenerkennung 203. Der Betragsbilder 201 liefert den Betrag an einen Schwellwertentscheider 202, der diesen Betrag mit einem konstanten Schwellwert vergleicht. Die Vorzeichenerkennung 203 ist an einen Schalter 26 als Ausgabe angeschlossen. Der Schwellwertentscheider 202 ist an einen Schalter 25 als Ausgabe angeschlossen. Werden die Schalter 25 und 26 geschlossen, liegt am Ausgang des Schalters 26 das erkannte Bit 205 und am Ausgang des Schalters 25 die Information 204 vor, ob das Bit zuverlässig erkannt worden ist. Die Schalter 25 und 26 werden von der Extremwertsuche 24 gesteuert.

Aus dem Register A wird der älteste Wert a_{old} (k) auf einen Multiplizierer 22 gegeben, der diesen Wert mit dem Faktor -2 multipliziert. Der Ausgang des Multiplikators ist mit der Rechenvorrichtung 23 verbunden, an die schon der Nullwert a_{new} (k) vom Verteiler 21 übertragen wurde. Als dritter Eingabewert für die Rechenvorrichtung 23 wird der älteste Wert des Schieberegisters B b_{old} (k) übertragen. Damit wird der Extremwert durch die Gleichung b_{old} (k) + a_{new} (k) - 2 · *a_{old}* (*k*) gebildet. Dieser Wert wird an die Extremwertsuche 24 übertragen.

Die Extremwertsuche dient dazu den Zeitpunkt festzustellen, der optimal für die Bitentscheidung ist. Die Änderung von x (k) auf den Folgewert x (k+1) ist lediglich durch die jeweils ältesten Bits a_{old} (k) bzw. b_{old} (k) der beiden Blöcke A und B und das Bit a_{new} (k), welches als nächstes in die Schieberegister, sprich Schieberegister A geschoben wird. Die Änderung des Ausgangs δ*x*(*k*) = *x*(*k* +1) - *x*(*k*) kann durch δ*x*(*k*) = *a_{new}*(*k*) + *b_{old}* (*k*) - *2a_{old}* (*k*) berechnet werden. Ist δ*x*(*k*) >0, so steigt x (k) mit dem nächsten Schritt bzw. sinkt, falls δ*x*(*k*) < 0 ist.

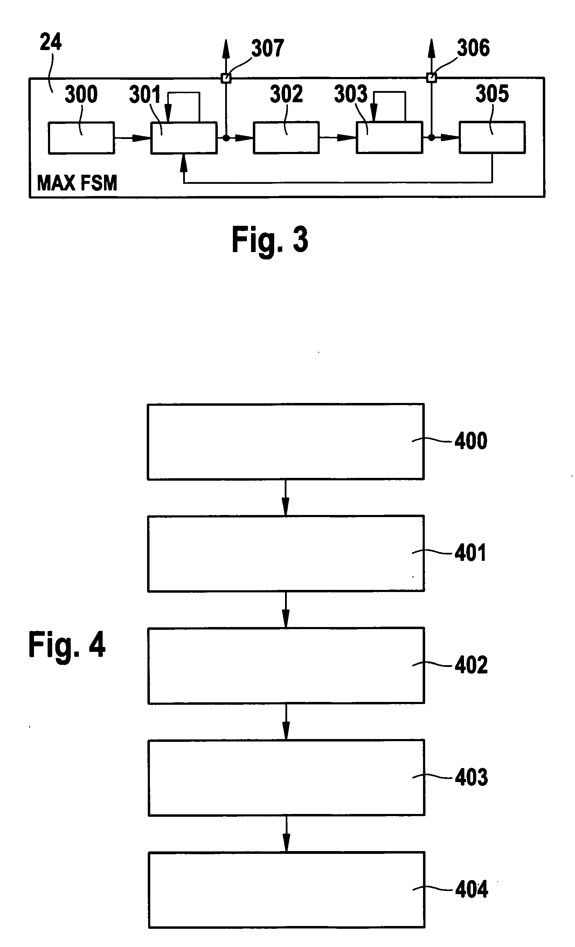

Mit der Größe δ*x*(*k*) und dem Zustandsautomaten gemäß Figur 3 lässt sich eine Extremwertsuche besonders effizient durchführen.

Figur 3 zeigt die Extremwertsuche 24 als Blockschaltbild. Im Block 300 wird die Extremwertsuche initiiert. Im Block 301 wird geprüft, ob der Eingabewert δ*x*(*k*) >0 ist, d.h. x von k+1 ist zum ersten mal nach einer mono steigenden Phase kleiner als sein Vorgängerwert x (k). Gleiches gilt mit umgekehrten Vorzeichen auch für die Minimumsuche. Am Ausgang 307 wird dann ein Schaltsignal für die Schalter 25 und 26 ausgegeben. Ist der Input jedoch kleiner als 0, dann wird in Verfahrensschritt 302 gewartet für eine vorgegebene Wartezeit, auf die im nächsten Abschnitt eingegangen wird. In Verfahrensschritt 303 wird dann geprüft, ob der Input < 0 ist, also ob wieder ein Vorzeichenwechsel vorliegt. Ist diese Prüfung durchbrochen, dann wird am Ausgang 306 ein weiterer Trigger ausgegeben. In dem Verfahrensschritt 305 wird erneut gewartet, um dann wiederum zu Verfahrensschritt 301 zurückzuspringen.

Treten in den Daten Sequenzen von logischen Nullen bzw. Einsen auf, so ergeben sich am Korrelatorausgang Extrema, die nicht regulären Abtastzeitpunkten entsprechen. Diese Nebenextrema gilt es zu filtern. Ein Nebenextrem tritt immer in der Mitte (0,5 *T_{bit}* zwischen zwei regulären Abtastzeitpunkten auf, so dass sie mit einem einfachen Timer gefiltert werden können. Diese Filterung wird von den Wartezuständen im Zustandsautomaten nach Figur 3 übernommen. Optimal wählt man die Wartezeit zu 75% der nominalen Bitdauer als Mittel zwischen 0,5 T_{bit} und T_{bit}.

Alternativ können auch aus der Literatur bekannte Verfahren zur Extremwertsuche verwendet werden.

Figur 4 zeigt ein Flussdiagramm des erfindungsgemäßen Verfahrens. In Verfahrensschritt 404 wird das manchestercodierte Signal durch die Schnittstelle im Steuergerät bereitgestellt. In Verfahrensschritt 401 wird die Decodierung beispielsweise durch die Komparatorprüfung des Komparators K initiiert. In Verfahrensschritt 402 erfolgt die Überabtastung, vorzugsweise mit dem Systemtakt des Steuergeräts. In Verfahrensschritt 403 erfolgt dann die eigentliche Codierung durch die Schiebegrillschieberegister in der oben beschriebenen Form und die Extremwertsuche um den Zeitpunkt optimal zu wählen, zu dem die Entscheidung getroffen sein soll, ob das Bit sicher detektiert ist oder nicht. In Verfahrensschritt 404 erfolgt dann die Ausgabe des decodierten Signals an die Auswerteschaltung, um zu entscheiden, ob Personenschutzmittel angesteuert werden sollen oder nicht.

## Patentansprüche

1. Steuergerät für den Personenschutz mit:
- einer Schnittstelle, die ein manchestercodiertes Signal bereitstellt
- einer Decodiereinheit (DEC), die das manchestercodierte Signal decodiert
- einer Auswerteeinheit (µC), die das decodierte Signal zur Ansteuerung von Mitteln zum Personenschutz verwendet, **dadurch gekennzeichnet, dass** die Decodiereinheit (DEC) zur Manchesterdecodierung eine Schieberegisterstruktur (A, B) aufweist und dass für das manchestercodierte Signal eine Überabtastung vorgesehen ist.

2. Steuergerät nach Anspruch 1, **dadurch gekennzeichnet, dass** die Schieberegisterstruktur zwei hintereinander geschaltete gleich lange Schieberegister (A, B) aufweist.

3. Steuergerät nach Anspruch 2, **dadurch gekennzeichnet, dass** für die zwei Schieberegister (A, B) jeweils eine Addiervorrichtung (27, 28) zur Summenbildung von Inhalten der zwei Schieberegister (A, B) vorgesehen ist, dass eine Subtraktionsvorrichtung (200, 29) für die beiden Summen zur Bildung einer Differenz vorgesehen ist, dass ein Betragsbilder (201 für die Differenz und ein Schwellwertentscheider für den Betrag, sowie eine Vorzeichenerkennung (203) für die Differenz vorgesehen sind und dass eine erste Ausgabe für den Schwellwertentscheider für eine Fehlererkennung und eine zweite Ausgabe für die Vorzeichenerkennung für die Ausgabe des decodierten Signals vorgesehen sind.

4. Steuergerät nach einem der vorhergehenden Ansprüche, **dadurch gekennzeichnet, dass** an die Schieberegisterstruktur eine Extremwertsuche angeschlossen ist, wobei die Extremwertsuche die Decodierung beeinflusst.

5. Steuergerät nach Anspruch 3 oder 4, **dadurch gekennzeichnet, dass** die Extremwertsuche mit der ersten und zweiten Ausgabe derart verbunden ist, dass die erste und die zweite Ausgabe eine Ausgabe bewirken, wenn ein Extremwert gefunden ist.

6. Steuergerät nach Anspruch 2 und 4 oder 5, **dadurch gekennzeichnet, dass** die Extremwertsuche derart gestaltet ist, dass der Extremwert in Abhängigkeit von einem neuen Abtastwert und den jeweiligen ältesten Abtastwerten des ersten und zweiten Schieberegisters bestimmt wird.

7. Steuergerät nach Anspruch 6, **dadurch gekennzeichnet, dass** ein Rechenglied vorgesehen ist, das den neuen Abtastwert den ältesten Abtastwert des ersten Schieberegisters und des ältesten Abtastwerts des zweiten Schieberegisters addiert, wobei der älteste Abtastwert des ersten Schieberegisters dafür mit -1 multipliziert wird.

8. Steuergerät nach einem der vorhergehenden Ansprüche, **dadurch gekennzeichnet, dass** die Schieberegisterstruktur eine Länge von einem Datenbit aufweist.

9. Steuergerät nach einem der vorhergehenden Ansprüche, **dadurch gekennzeichnet, dass** die Überabtastung einen Arbeitstakt des Steuergeräts verwendet.

10. Verfahren zur Ansteuerung von Mitteln zum Personenschutz mit folgenden Verfahrensschritten:
- Bereitstellen eines manchestercodierten Signals
- Decodierung des manchestercodierten Signals
- Verwendung des decodierten Signals zur Ansteuerung der Mittel zum Personenschutz, **dadurch gekennzeichnet, dass** zur Manchesterdecodierung eine Schieberegisterstruktur (A, B) und eine Überabtastung des Signals verwendet werden.

## Claims

1. Control device for personal protection comprising:
- an interface which makes available a Manchester-encoded signal,
- a decoding unit (DEC) which decodes the Manchester-encoded signal,
- an evaluation unit (µC) which uses the decoded signal to actuate personal protection means, **characterized in that** the decoding unit (DEC) for forming Manchester decoding has a shift register structure (A, B), and **in that** oversampling is provided for the Manchester-encoded signal.

2. Control device according to Claim 1, **characterized in that** the shift register structure has two shift registers (A, B) which are of equal length and are connected one behind the other.

3. Control device according to Claim 2, **characterized in that** in each case an adding device (27, 28) for summing contents of the two shift registers (A, B) is provided for each of the two shift registers (A, B), **in that** a subtraction device (200, 29) is provided for forming a difference for the two sums, **in that** an absolute value former (201) is provided for the difference, a threshold value decision element is provided for the absolute value, and a sign detection means (203) is provided for the difference, and **in that** a first output is provided for the threshold value decision element for detecting faults, and a second output is provided for the sign detection means for outputting the decoded signal.

4. Control device according to one of the preceding claims, **characterized in that** an extreme value search means is connected to the shift register structure, wherein the extreme value search means influences the decoding.

5. Control device according to Claim 3 or 4, **characterized in that** the extreme value search means is connected to the first and second outputs such that the first and the second outputs bring about an output when an extreme value is found.

6. Control device according to Claims 2 and 4 or 5, **characterized in that** the extreme value search means is configured in such a way that the extreme value is determined as a function of a new sampled value and the respective oldest sampled values of the first and second shift registers.

7. Control device according to Claim 6, **characterized in that** a computing element is provided which adds the new sampled value, the oldest sampled value of the first shift register and the oldest sampled value of the second shift register, wherein the oldest sampled value of the first shift register is multiplied for this by -1.

8. Control device according to one of the preceding claims, **characterized in that** the shift register structure has a length of one data bit.

9. Control device according to one of the preceding claims, **characterized in that** the oversampling uses a working clock of the control device.

10. Method for actuating personal protection means, having the following method steps:
- provision of a Manchester-encoded signal,
- decoding of the Manchester-encoded signal,
- use of the decoded signal to actuate the personal protection means, **characterized in that** a shift register structure (A, B) and oversampling of the signal are used for the Manchester decoding.

## Revendications

1. Contrôleur pour la protection de personnes comprenant :
- une interface qui délivre un signal à codage Manchester
- une unité de décodage (DEC) qui décode le signal à codage Manchester
- une unité d'interprétation (µC) qui utilise le signal décodé pour commander des moyens de protection de personnes, **caractérisé en ce**
**que** l'unité de décodage (DEC) présente pour le décodage du signal à codage Manchester une structure de registre à décalage (A, B) et en ce qu'un suréchantillonnage est prévu pour le signal à codage Manchester.

2. Contrôleur selon la revendication 1, **caractérisé en ce que** la structure de registre à décalage présente deux registres à décalage (A, B) de même longueur branchés l'un derrière l'autre.

3. Contrôleur selon la revendication 2, **caractérisé en ce qu'**un dispositif additionneur (27, 28) est à chaque fois prévu pour les deux registres à décalage (A, B) pour calculer la somme des contenus des deux registres à décalage (A, B), **en ce qu'**il est prévu un dispositif soustracteur (200, 29) pour les deux sommes en vue de calculer une **différence, en ce qu'**il est prévu un calculateur de montant (201) pour la différence et un décideur de valeur de seuil pour le montant ainsi qu'une détection de signe (203) pour la **différence et en ce qu'**une première sortie du décideur de valeur de seuil est prévue pour une détection de défaut et une deuxième sortie pour la détection de signe pour la délivrance du signal décodé.

4. Contrôleur selon l'une des revendications précédentes, **caractérisé en ce qu'**une recherche de valeur extrême est connectée à la structure de registre à décalage, la recherche de valeur extrême influençant le décodage.

5. Contrôleur selon la revendication 3 ou 4, **caractérisé en ce que** la recherche de valeur extrême est reliée avec la première et la deuxième sortie de telle sorte que la première et la deuxième sortie produisent une sortie lorsqu'une valeur extrême est trouvée.

6. Contrôleur selon les revendications 2 et 4 ou 5, **caractérisé en ce que** la recherche de valeur extrême est configurée de telle sorte que la valeur extrême est déterminée en fonction d'une nouvelle valeur échantillonnée et des valeurs échantillonnées respectivement les plus anciennes du premier et du deuxième registre à décalage.

7. Contrôleur selon la revendication 6, **caractérisé en ce qu'**il est prévu un élément de calcul qui additionne la nouvelle valeur échantillonnée et la valeur échantillonnée la plus ancienne du premier registre à décalage et la valeur échantillonnée la plus ancienne du deuxième registre à décalage, la valeur échantillonnée la plus ancienne du premier registre à décalage étant à cet effet multipliée par -1.

8. Contrôleur selon l'une des revendications précédentes, **caractérisé en ce que** la structure de registre à décalage présente une longueur d'un bit de données.

9. Contrôleur selon l'une des revendications précédentes, **caractérisé en ce qu**e le suréchantillonnage utilise un cycle de fonctionnement du contrôleur.

10. Procédé de commande de moyens pour la protection de personnes comprenant les étapes suivantes .
- délivrance d'un signal à codage Manchester
- décodage du signal à codage Manchester
- utilisation du signal décodé pour commander les moyens de protection de personnes, **caractérisé en ce qu'**une structure de registre à décalage (A, B) et un suréchantillonnage du signal sont utilisés pour le décodage Manchester.
